# EUROPEAN PATENT SPECIFICATION

(11) **EP 4 754 766 B1**
(45) Date of publication and mention of the grant of the patent: **04.11.2026**
(21) Application number: 25765430.1
(22) Date of filing: 05.08.2025
(51) Int. Cl.: G11C 7/10

(54) **AUTO-INDEXING MECHANISMS FOR REDUCTION-BASED PROCESSING-IN-MEMORY ARCHITECTURES**
AUTOMATISCHE INDEXIERUNGSMECHANISMEN FÜR REDUKTIONSBASIERTE VERARBEITUNGS-IN-SPEICHER-ARCHITEKTUREN
MÉCANISMES D'AUTO-INDEXATION POUR ARCHITECTURES DE TRAITEMENT EN MÉMOIRE REPOSANT SUR LA RÉDUCTION

(30) Priority: 08.08.2024 US 202463681131 P
(43) Date of publication of application: 10.06.2026
(73) Proprietor: Google LLC, Mountain View, CA 94043 (US)
(72) Inventor: CHO, Benjamin Youngjae, Mountain View, California 94043 (US); YOON, Hongil, Mountain View, California 94043 (US); HWANG, Inho, Mountain View, California 94043 (US); PERUGUPALLI, Alekhya, Mountain View, California 94043 (US)
(74) Representative: Marks & Clerk GST
(86) International application number: PCT/US2025/040728
(87) International publication number: WO 2026/035735

(56) References cited:
- WO-A1-2022/047802
- WO-A1-2023/224614
- US-A1- 2023 205 693

## Description

### CLAIM OF PRIORITY

This application claims priority under 35 USC §119(e) to U.S. Patent Application Serial No. 63/681,131, filed on August 8, 2024.

### BACKGROUND

This specification relates to performing machine-learning computations using a special-purpose hardware computing unit.

Modern computing systems often incorporate a wide variety of compute processing units that each offer different computing capabilities and trade-offs. Efficient execution of a given compute job often involves parsing computations into meaningful subtasks or workloads that are mapped to available processor cores of a computing system. The computations may be parsed and mapped based on suitability criteria, such as processor capability, performance, and power. Generally, this overall process of allocating portions of a computation to appropriate processor resources is referred to as heterogeneous computing.

At least one processor core of a System-on-Chip ("SoC") can be an Intellectual Property block ("IP block") that executes a respective portion of a computational operation for different multimedia workloads. Example use cases can involve processing image or speech data captured respectively by a camera or microphone on the mobile device as well as performing computations for generative artificial intelligence ("GenAl") applications. The system-on-chip can use a heterogeneous compute operation to process input samples derived from image data, speech data, a text corpus, or a combination of these. An example step in the heterogeneous compute operation can include processing data associated with the input samples using a memory device that provides in-memory processing or computing capabilities.

Document WO 2022/047802 A1 discloses a processing-in-memory device including a memory array configured to store data and a computing circuit.

### SUMMARY

Example machine-learning computations, such as computing convolutions, often require numerous matrix multiplications in a large dimensional space, which can be performed in hardware using a computational unit of a special-purpose hardware integrated circuit, such as a neural network processor, tensor processor, or hardware accelerator. A processor or hardware controller of the integrated circuit can pass control signals to the computational unit to execute compute-intensive matrix multiplications that involve repeatedly calculating products and partial sums for the convolutions. The degree to which the processor parallelizes calculations is limited due to its architecture.

This specification describes a hardware and software architecture(s) and associated techniques providing a programmable auto-indexing mechanism for input/output activations and weights, where the mechanism automatically calculates and tracks various register IDs and index values for activations as well as row/column indices and distance values for obtaining accurate weight scales. The programmable auto-indexing mechanism is configured to support and/or exploit output-activation sparsity within a Reduction-based Processing-in-Memory (PiM) architecture of an integrated memory device (e.g., DRAM). Upon determining indices associated with input/output activations and weights, the computational unit can perform memory read operations to obtain input activations and/or weights and perform memory write operations to write output activations.

In the context of the present specification, a weight scale is a numerical factor used to adjust a magnitude of weights during scaling operations within PiM compute units. In some cases, the scaling operation is performed when quantizing weights (e.g., reducing precision) and/or activations to ensure efficient computation and optimal model performance. In some cases, weight scales are larger and less re-usable in comparison with activation scales, requiring the weight scales to be read from DRAM during PiM execution.

Other implementations of this and other aspects include corresponding systems, apparatus, and computer programs, configured to perform the actions of the methods, encoded on computer storage devices. A system of one or more computers can be so configured by virtue of software, firmware, hardware, or a combination of them installed on the system that in operation causes the system to perform the actions. One or more computer programs can be so configured by virtue of having instructions that, when executed by a data processing apparatus, cause the apparatus to perform the actions.

The subject matter described in this specification can be implemented in various configurations to realize one or more of the following advantages. Techniques are described for providing a programmable auto-indexing mechanism implemented by PiM devices of an integrated memory device. The programmable auto-indexing mechanism allows for more efficient calculations involving processing input and output activations and weights associated with neural network calculations, as communication between the PiM devices and a host device is reduced. In addition, computational overhead of the host device is reduced by enabling automatic calculation and tracking of register identifiers within the PiM devices. Furthermore, the programmable auto-indexing mechanism allows for reduced communication latency and improved data throughput by minimizing communication overhead between the host device and the PiM devices during computation.

In an aspect, a method performed using a Processing-in-Memory ("PiM") architecture of an integrated memory device includes, for a first PiM command, storing a first location index corresponding to a row and column of a memory bank from which a first weight scale is obtained and executing a computation using the first weight scale based on the first PiM command. For a second PiM command, the method includes computing a distance value based on the first location index and index location information of a second weight, determining, based on the distance value, a second weight scale index for obtaining a second weight scale, and executing, based on the second PiM command, a computation using the second weight scale obtained using the second weight scale index.

In some implementations, storing a location index corresponding to the row and column of the memory bank includes storing the location index in a hardware-controlled register of a PiM block included in the PiM architecture. In some implementations, storing a location index corresponding to the row and column of the memory bank includes i) storing, in a first register, a row index corresponding to a row of the row and column of the memory bank and (ii) storing, in a second register, a column index corresponding to a column of the row and column of the memory bank. In some implementations, i) the first register is a weight scale row register and ii) the second register is a weight scale column register.

In some implementations, the method includes loading the weight scale into a weight scale register of the PiM block, and performing, based on the weight scale, a scaling operation in response to executing machine-learning computations at a compute unit of the PiM block.

In some implementations, the method includes obtaining a plurality of weight scales in response to reading, from the memory bank, respective data values for each of the plurality of weight scales, wherein each of the plurality of scales is for a scaling operation against a respective weight value used in a machine-learning computation executed by a compute unit of the PiM architecture.

In some implementations, the method includes configuring an output-activation sparsity exploitation mode of the PiM architecture based on a mode configuration value that indicates a non-linear access pattern for accessing weight scales stored in the memory bank. In some implementations, the mode configuration value is a reduction bit that is set in a PiM execute command that is received at the PiM architecture from a host device that communicates with the memory device. In some implementations, the reduction bit is set based on a configurable binary value of 0 or 1. In some implementations, the method includes determining that the reduction bit is set and triggering a reduction mode of the PiM architecture in response to determining that the reduction bit is set.

In an aspect, a Processing-in-Memory ("PiM") architecture of an integrated memory device includes at least one processor of a PiM device of the PiM architecture and a memory of the PiM device storing instructions that, when executed by the at least one processor of the PiM device, cause the at least one processor to perform operations that include, for a first PiM command, storing a first location index corresponding to a row and column of a memory bank from which a first weight scale is obtained and executing a computation using the first weight scale based on the first PiM command. The operations include, for a second PiM command, computing a distance value based on the first location index and index location information of a second weight, determining, based on the distance value, a second weight scale index for obtaining a second weight scale, and executing, based on the second PiM command, a computation using the second weight scale obtained using the second weight scale index.

In some implementations, storing a location index corresponding to the row and column of the memory bank includes storing the location index in a hardware-controlled register of a PiM block included in the PiM architecture.

In some implementations, storing a location index corresponding to the row and column of the memory bank includes i) storing, in a first register, a row index corresponding to a row of the row and column of the memory bank and ii) storing, in a second register, a column index corresponding to a column of the row and column of the memory bank.

In some implementations, i) the first register is a weight scale row register and ii) the second register is a weight scale column register.

In some implementations, the operations include loading the weight scale into a weight scale register of the PiM block and performing, based on the weight scale, a scaling operation in response to executing machine-learning computations at a compute unit of the PiM block.

In some implementations, the operations include obtaining a plurality of weight scales in response to reading, from the memory bank, respective data values for each of the plurality of weight scales, wherein each of the plurality of scales is for a scaling operation against a respective weight value used in a machine-learning computation executed by a compute unit of the PiM architecture. In some implementations, the operations further include configuring an output-activation sparsity exploitation mode of the PiM architecture based on a mode configuration value that indicates a non-linear access pattern for accessing weight scales stored in the memory bank. In some implementations, the mode configuration value is a reduction bit that is set in a PiM execute command that is received at the PiM architecture from a host device that communicates with the memory device. In some implementations, the reduction bit is set based on a configurable binary value of 0 or 1. In some implementations, the operations include determining that the reduction bit is set and triggering a reduction mode of the PiM architecture in response to determining that the reduction bit is set.

The details of one or more implementations of the subject matter described in this specification are set forth in the accompanying drawings and the description below. Other potential features, aspects, and advantages of the subject matter will become apparent from the description, the drawings, and the claims.

### BRIEF DESCRIPTION OF THE DRAWINGS

Fig. 1 is a block diagram of an example computing system with at least one SoC and integrated memory device.
Figs. 2A & 2B illustrate examples of PiM architectures for an integrated memory device.
Fig. 3 shows an example parameter tensor with K in M sparsity.
Fig. 4 shows example reduction-based PiM architecture for exploiting output activation sparsity.
Fig. 5 illustrates an example configuration of a reduction-based PiM architecture.
Fig. 6 illustrates an example of a first auto-indexing scheme performed at a PiM block of a reduction-based PiM architecture.
Fig. 7 illustrates an example of a second auto-indexing scheme performed at a PiM block of a reduction-based PiM architecture.
Fig. 8 illustrates an example indexing scheme performed at a PiM block based on a distance-based weight-scale index calculation.
Fig. 9 illustrates a schematic for accessing weight scales under output sparsity.
Fig. 10 is an example process for automatically updating register indices for a PiM computation.

Like reference numbers and designations in the various drawings indicate like elements.

### DETAILED DESCRIPTION

Large Language Models (LLMs) benefit significantly from leveraging sparse output activations in their Feed-forward Network (FFN) layers. This sparsity is key to achieving high performance and energy efficiency. Reduction-based Processing-in-Memory (PiM) architectures are well-suited for accelerating FFN computations that exploit this output activation sparsity. A challenge in reduction-based PiM architectures is the limited communication bandwidth between the host processor and PiM during computation. This is due to shared paths for reduction operations and host-PiM communication.

To overcome this limitation, the host processor can send all necessary information to the PiM compute units before computation begins. This pre-loading enables PiM units to operate more autonomously, ideally without requiring further communication from the host during computation. This reduces communication overhead and improves overall efficiency. Specifically, PiM should function effectively without needing input/output activation index function or weight-scale index information from the host during computation.

To address the aforementioned challenges, a programmable auto-indexing mechanism for input/output activations is proposed that allow for leveraging input/output access patterns to automatically update register indices after each compute iteration involving non-sparse data values or operands. In addition, distance-based weight-scale index calculations are proposed to infer weight scale indices by calculating the distance between the weight-scale and weight DRAM columns, e.g., based on a last recorded row and column indices of a prior weight scale. With this, an improved efficiency and autonomy of PiM compute units in accelerating FFN layers of LLMs can be achieved.

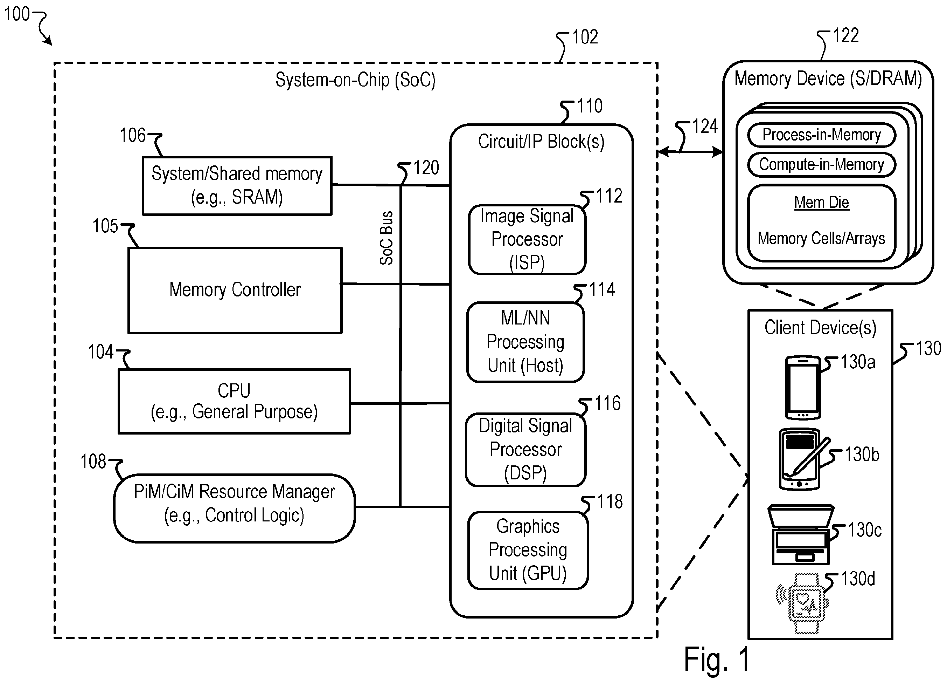

Fig. 1 is a block diagram of an example computing system 100 that includes a system-on-chip 102 ("SoC 102"). The SoC 102 includes a central processing unit 104 ("CPU 104"), a memory controller 105, a shared memory 106 ("memory 106"), a resource manager 108, and an IP/circuit block 110. In some implementations, system 100 can include multiple SoCs and any descriptions for the SoC 102 will apply equally to each of the multiple SoCs that may be included at system 100.

The CPU 104 can be a general-purpose CPU (e.g., a single or multi-core CPU). The CPU 104 generates one or more indicators, such as an app-launch indicator or a function call that is triggered in response to executing or launching an application at a user device. For example, the application can be a camera application that uses an imaging sensor to generate image data or a gaming application that requires substantial memory and graphics processing resources to render graphical content of the game. The CPU 104 also generates one or more application values, such as pixel values or frame rate. The application values may be associated with a function call, may be descriptive of an event that occurs during execution of the application, or both.

The memory 106 is a system memory, shared memory, or both. In the example of Fig. 1, memory 106 is depicted external to circuit block 110. However, memory 106 can include portions of memory that are: i) specific to circuit block 110, ii) external to circuit block 110, or iii) both. The memory 106 can be random access memory of the SoC 102, such as static random-access memory (SRAM), dynamic random-access memory (DRAM), a synchronous DRAM (SDRAM), or double data rate (DDR) SDRAM.

In some implementations, aspects of memory 106 are configured as a shared scratchpad memory that supports parallel access of its memory resources by two or more processors of the circuit 110. The memory 106 can also include various other types of memory, such as high bandwidth memory (HBM), narrow memory (e.g., for storing 8-bit values), wide memory (e.g., for storing 16-bit or 32-bit values), etc.

The resource manager 108 is implemented in hardware and software. Aspects of the resource manager 108 can be also implemented as firmware of the SoC 102 or firmware of a device of the SoC 102, such as a DRAM memory device or the CPU 104. The resource manager 108 is a processor-in-memory (PiM) resource manager ("PiM resource manager 108") that includes control logic implemented in hardware, software, or both. For example, the PiM resource manager 108 can include resources such as flip-flops, registers, buffers, etc. that are implemented in hardware and control logic (e.g., programmed code) that is implemented in software.

The circuit block 110 generally includes individual IP devices such as processors, processor cores, or special-purpose processing devices. For example, the circuit block 110 can include an image signal processor (ISP) 112, a host (or special purpose) processing unit (HPU) 114, a digital signal processor (DSP) 116, and a graphics processing unit (GPU) 118. The circuit block 110 is referred to alternatively as an IP block 110, where the IP block can include one or more proprietary hardware elements. For example, each of the ISP 112, HPU 114, DSP 116, and GPU 118 can be a respective proprietary IP block (or IP device) of a particular entity or device manufacturer.

One or more aspects of the PiM resource manager 108 can be implemented as a software routine (or module) of the CPU 104, which uses one or more hardware resources of the CPU 104, such as registers, buffers, etc. The CPU 104 can be configured as an instruction and vector data processing engine that processes data obtained from a system memory of the SoC 102, such as memory 106. In some implementations, each processor (e.g., ISP 112, DSP 116, HPU 114, GPU 118) of the SoC 102 includes multiple cores and the CPU 104 and/or the PiM resource manager 108 can generate control signaling 124 to manage and distribute memory intensive compute operations to a memory device 122 (e.g., DRAM) to minimize the processing load at each core of the processors. The control signaling 124 is routed at system 100 using an example bus 120 of the SoC 102. The control signaling 124 can include commands, requests, data, instructions, or combination of these.

The PiM resource manager 108 cooperates with the CPU 104, memory controller 105, and/or host processor to dynamically control and manage one or more compute-in-memory (CiM) operations. In some implementations, the CiM operations are executed at the SoC 102 in support of a heterogeneous compute operation between two or more processing units that are included among the IP block 110, the CPU 104, or both. More specifically, the PiM resource manager 108 is configured to generate control signaling 124 and use one or more discrete signal values of the control signaling 124 to initiate and manage PiM operations at the memory device 122.

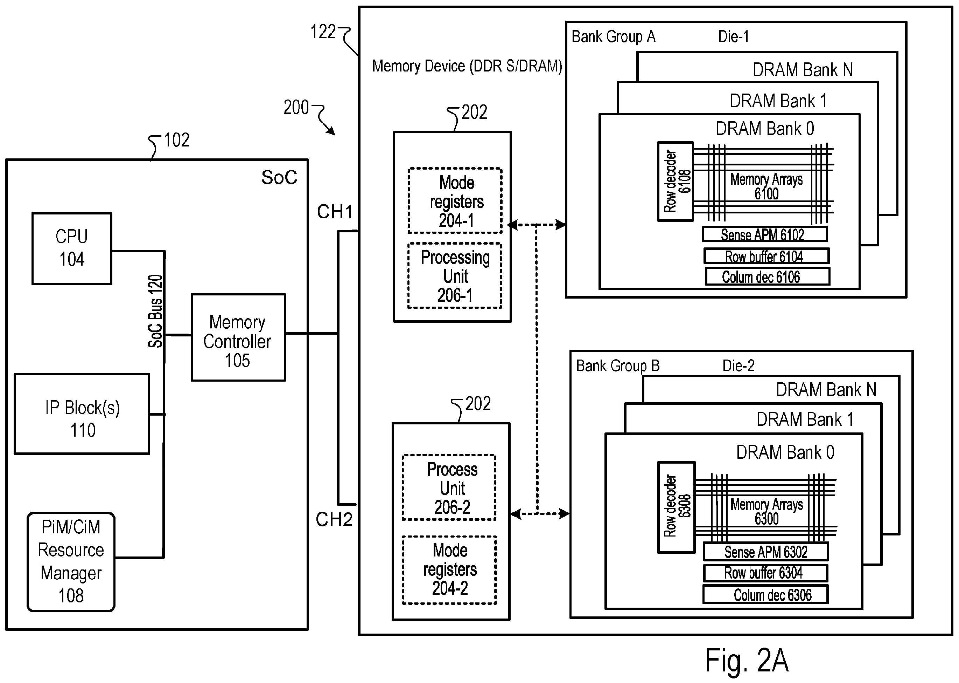

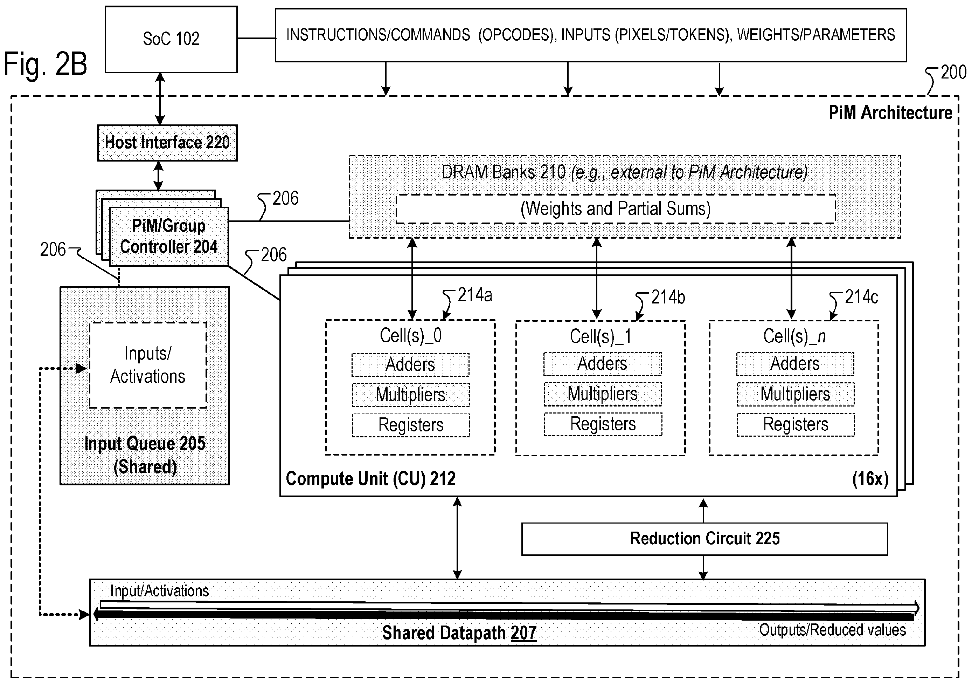

The system 100 includes an example memory device 122. The memory device 122 can include multiple memory dies. For example, the memory device 122 can include N memory die, where N is an integer greater than 1. The memory device 122 can be a dynamic random-access memory (DRAM) or Double Data Rate (DDR) synchronous DRAM (SDRAM). The memory device 122 is configured to perform or support various types of PiM operations, CiM operations, and memory-near-computing operations ("MnC operations"). The memory device 122 performs or supports these operations using data processing resources and/or compute elements of its PiM architecture, which are described below with reference to at least Figs. 2A and 2B.

The SoC 102 cooperates with the memory device 122 to perform computations across one or more bank groups of the memory device 122. The computations can be for operations or workloads that involve one or more of the processors at IP block 110. Additionally, the computations can be for a heterogeneous operation that spans multiple processors of IP block 110, multiple IP blocks 110, or both. In at least one example the memory device 122 may be external to the SoC 102, whereas in another example the memory device 122 may be internal to the SoC 102.

In the example of Fig. 1, system 100 and the SoC 102 are integrated circuits of an example user/client device 130, consumer electronic device, or mobile device, where each of these devices can include items such as a smartphone 130a, tablet 130b, laptop 130c, smartwatch or wearable device 130d. The devices 130 may also include other items such as an eNotebook, Netbook, smart speaker, or mobile computer. In some implementations, the system 100 and the SoC 102 are integrated circuits of a desktop computer, network server, or related cloud-based asset.

Fig. 2A and Fig. 2B illustrate examples of PiM architectures for an integrated memory device.

Fig. 2A shows an example processor-in-memory (PiM) architecture 200 for initiating, controlling, and/or boosting PiM computations and data access performance based on control signals generated using the SoC 102, the memory device 122, or both. In the example of Fig. 2A, the memory device 122 includes a first memory die-1 with a first bank group that has multiple memory banks, where each memory bank includes one or more memory arrays and a second memory die-2 with a second bank group that has multiple memory banks, where each memory bank includes one or more memory arrays. In some implementations, the PiM architecture 200 includes multiple bank groups, multiple memory die, or both. For example, a single memory die can include multiple bank groups and/or multiple bank groups can be distributed across multiple memory die.

The PiM architecture 200 includes multiple PiM blocks, where each PiM block includes multiple compute elements. For example, a first PiM block of PiM architecture 200 includes mode register 204-1 and process unit 206-1, whereas a second, different PiM block of PiM architecture 200 includes mode register 204-2 and process unit 206-2. Each process unit 206-1, 206-2 can include a processor, a processor unit, or a processor core, such as a CPU. Each process unit 206-1, 206-2 can also include an example computation unit such as an arithmetic logic unit (ALU) or multiply-accumulate cell (MAC).

In some implementations, the PiM architecture 200 is included in the memory device 122 as multiple discrete integrated circuits, where each integrated circuit is local to a given memory die (e.g., die-1 and die-2) and interacts or communicates with arrays of memory cells at that memory die. For example, the PiM architecture 200 can include compute elements that are replicated and distributed across each of the memory die in the memory device 122. In some other implementations, the PiM architecture 200 is included in the memory device 122 as a single integrated circuit that interacts or communicates with each memory die of the memory device 122, including the arrays of memory cells at each memory die.

The PiM blocks or process units in the PiM architecture 200 are located within the memory device 122 but outside of a section of the memory device 122 that includes the bank groups. The section may be defined as a discrete memory die or defined in some other way (e.g., a portion of a memory die). Irrespective of the hardware configuration or layout of PiM architecture 200, the PiM blocks are sufficiently external to the bank groups such that the PiM blocks can communicate with the bank groups based on a particular timing constraint that is leveraged to boost PiM data access performance with cross bank group data aggregation. In some implementations, a data channel/interconnection can be established between the individual memory arrays of a memory bank and a corresponding processor unit and/or mode register of a PiM block 202.

The PiM operations can be managed and executed at the memory device 122 using a processor device that provides functionality similar to a central processor, such as CPU 104. The CiM operations and MnC operations can include standard arithmetic operations, such as computations normally performed by an ALU or MAC. The CiM operations and MnC operations can also include computational functions of a HPU 114, such as multiplication and addition operations for matrix math, vector computations, linear algebra, and dot-product accumulations. In some implementations, each of the PiM operations, CiM operations, and MnC operations are performed in support of machine-learning computations, neural network computations, or both.

In some implementations, the PiM operations are an extension of the computational functions of the HPU 114. For example, a PiM block can generate accumulated values from sets of weight values/inputs and activation inputs obtained from memory banks of different bank groups in the memory device 122. The accumulated values are generated based on neural network computations performed using a computational array of the PiM block. The computational array can be a matrix multiplication unit with compute cells that are arranged as a systolic array. The accumulated values can be dot products of the sets of weight values and the activation inputs. That is, for a set of weights, the PiM block multiplies each weight with each activation input and sums the products together to form an accumulated value.

The PiM architecture 200 can include a register or other portion of memory for storing data for a respective memory die or group of memory banks. For example, the data can be mode/configuration/throttling values. The data can also describe errors that occurred during a compute operation at a corresponding PiM block of the memory device 122, or both. In some implementations, the register or other portion of memory is used to store thermal throttling information, or associated instructions, for configuring aspects of a PiM block, or respective memory die, group of memory banks, or a combination of these.

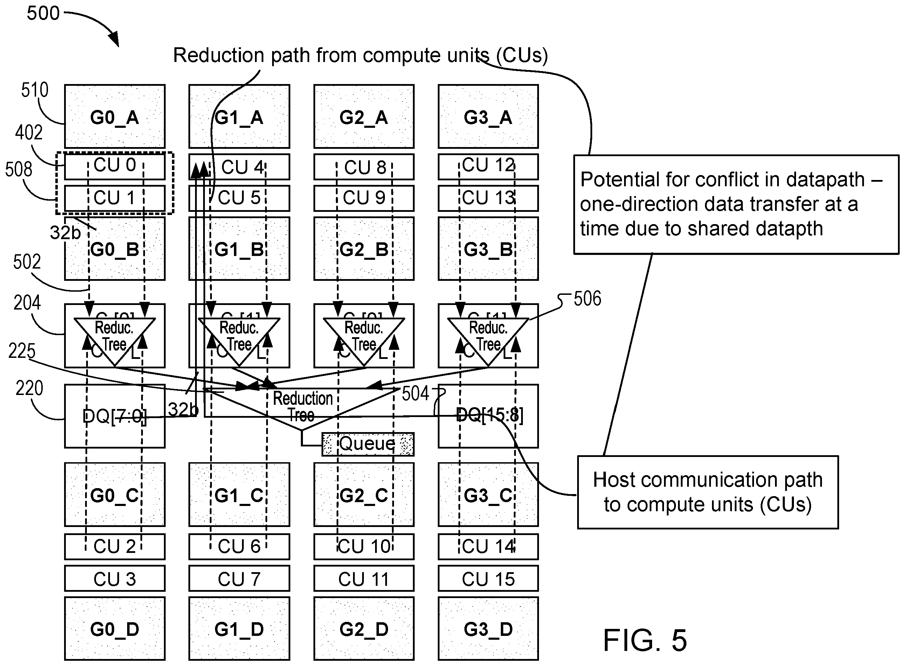

For example, the mode registers 204-1, 204-2 can be used to control or trigger selection of a particular mode in a PiM architecture, such as an error-capture mode, throttle mode, interleave configuration mode, multi-batch processing mode, broadcast input mode, or unicast input mode. In some implementations, a particular mode is selected based on bit values of the mode registers 204-1, 204-2. For example, to trigger or select a broadcast input mode(s) or multi-batch processing mode(s), a single bit, or a sequence of bits, can be defined for use in the mode register. This is described in more detail below at least with reference to the examples of Figs. 5-10.

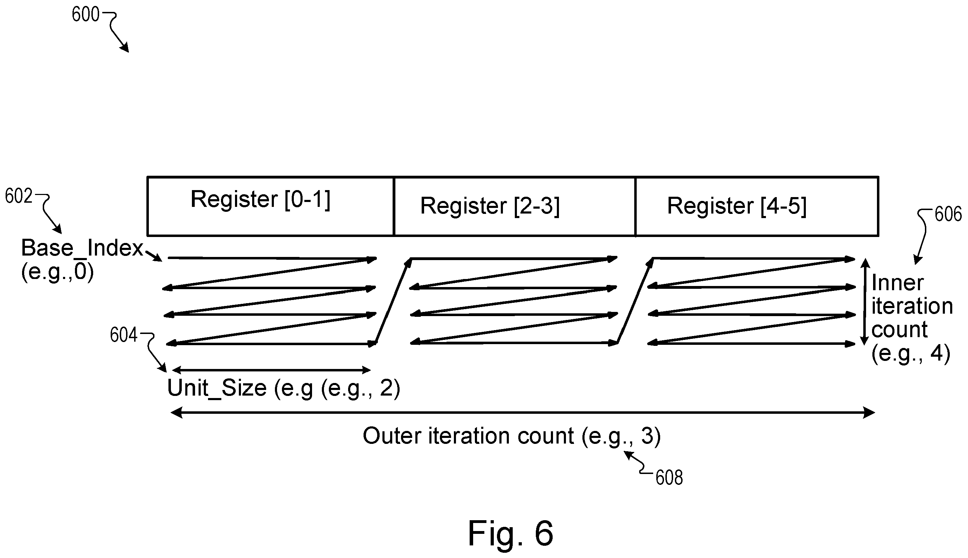

In some implementations, data access operations can be optimized at the memory device 122 by reading memory cells of bank groups at a frequency that exceeds other read operations that are subject to certain delay constraints for executing successive reads against banks of the memory device 122. For example, an internal controller of the PiM block (1), (2) can execute successive read commands at a frequency that is based on a clock cycle generated by the memory device 122. The internal controller can operate based on a particular clock frequency, e.g., a 200 or 800 MHz clock or 1000 MHz clock. Other clock frequencies are also within the scope of this disclosure. An example controller(s) is described below at least with reference to Fig. 6.

In the example of Fig. 2B, the PiM architecture 200 can represent an example computing system for implementing a neural network or machine-learning model in hardware using a hardware integrated circuit architecture of a memory device. The PiM architecture 200 includes one or more group controllers 204 ("controller 204") and a host interface 220 that communicates with the SoC 102. As described in more detail below, the host interface 220 and group controllers 204 cooperate to provide datasets and control signals to one or more compute units 212 of the PiM architecture 200.

The PiM architecture 200 generally includes multiple group controllers 204 that each provide or generate control signals 206 to cause inputs (or activations) to be stored at, or accessed from, memory locations of shared input queue 205. Likewise, the group controllers 204 can also generate control signals 206 to cause weights (or parameters) for a matrix structure of weights (and/or partial sums or accumulated values) to be stored at, or accessed from, memory locations of memory 210 (e.g., DRAM banks).

The inputs can be represented by an input tensor, whereas the matrix structure of weights is represented by a parameter tensor. Each of the input tensor and the parameter tensor may be multi-dimensional data structures, such as a multi-dimensional matrix or tensor. In some implementations, input samples stored in the shared queue 205 include data values that represent image pixels, word tokens, and/or related activation values, whereas the weights are for a neural network layer through which an input sample is processed to generate a corresponding layer output.

The PiM architecture 200 includes a shared datapath 207 and multiple computational units ("compute units") 212. Each compute unit 212 includes arithmetic circuitry with multiply accumulators (MACs) that form one or more MAC cells 214 a/b/c. In some implementations, each compute unit 212 can include *N* number of cells, where *N* is an integer greater than or equal to one. The MAC cells 214 perform arithmetic operations such as multiplication and addition. For example, each MAC cell 214 can be used to compute dot products and related matrix multiplications that are performed to convolve an input tensor of image pixel values with a weight tensor (e.g., a kernel filter of weights). In some implementations, the computations are convolution operations performed to generate an output for a convolutional neural network layer.

In some implementations, the compute units 212 includes an array of MAC cells 214 and PiM blocks 202 of the PiM architecture 200 can be configured to supplement or complement the computational capacity of example special-purpose processor, such as HPU 114 or a neural network processor that executes an ML model to process an inference workload. The PiM architecture 200 leverages compute units 212, timing interval controls, configuration values for input broadcasting (or unicasting) and multi-batch processing to efficiently execute PiM computations by exploiting input/output sparsity.

Leveraging these techniques, for large inference workloads (e.g., LLM or GenAI task), the HPU 114 and/or the SoC 102 can offload a portion of the inference computations to the computational units 212 of PiM architecture 200, thereby expanding or extending the computational capacity of the HPU 114. In some implementations, this inference processing can involve computing convolutions, e.g., group convolutions, where data values and/or operands for an input sample, such as words or pixels, and weight values of a neural network layer are routed to the MAC cells 214 of the compute units 212 to execute the convolution via computations performed at the MAC cells 214 a/b/c. Each weight value can be represented using 2 bytes (2B). More specifically, each weight value can be a 16-bit Bfloat number (BF16) or a 32-bit floating point number (FP32).

Each group controller 204 can generate control signals 206 to obtain or route operands stored at the shared queue 205 and memory 210 of the PiM architecture 200. For example, group controller 204 can generate control signals 206 to obtain inputs stored at shared queue 205 and weights stored at memory 210 and initiate/execute neural network and/or machine-learning computations at the compute units 212. Each input obtained from shared queue 205 is routed along the shared datapath 207 to a MAC cell 214 a/b/c in a compute unit 212. The weights obtained from memory 210 can be passed to a corresponding compute unit 212 via a direct datapath based on a tight/close coupling of compute units 212 to DRAM banks/cells of memory device 122.

As described below, each compute unit 212 performs computations that produce partial sums or accumulated values for generating outputs for a neural network layer or machine-learning task. In some implementations, an activation function may be applied to a set of outputs to generate a set of output activations for a neural network layer. The outputs (or output activations) computed at the PiM architecture 200 are routed to the shared queue 205 via the shared datapath 207.

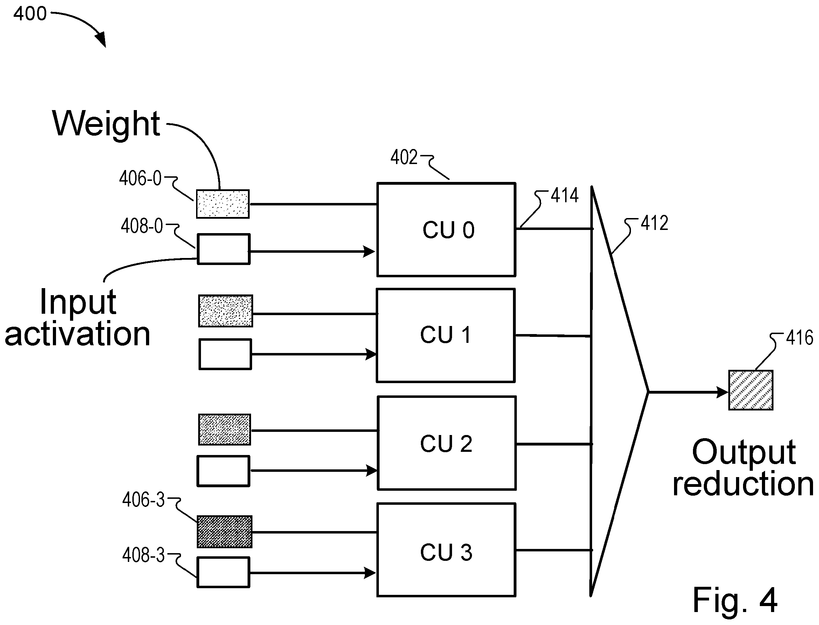

In some implementations, each compute unit 212 generates a set of accumulated values that are reduced to an output or output activation via a reduction operation executed by a reduction circuit 225 of the PiM architecture 200. The reduction circuit 225 is described below at least with reference to the example of Figs. 4-6. In some examples, a set of values associated with a first neural network layer can be generated by a first compute unit 212, routed from the first compute unit 212 to the shared queue 205 via the shared datapath 207, buffered/stored at the shared queue 205, and then routed from the shared queue 205 via the shared datapath 207 to a second, different compute unit 212. In some implementations, the data routed for processing at the second compute unit 212 are output activations of a first neural network layer, which are then provided as input activations for a second, different layer of a neural network implemented using the PiM architecture 200.

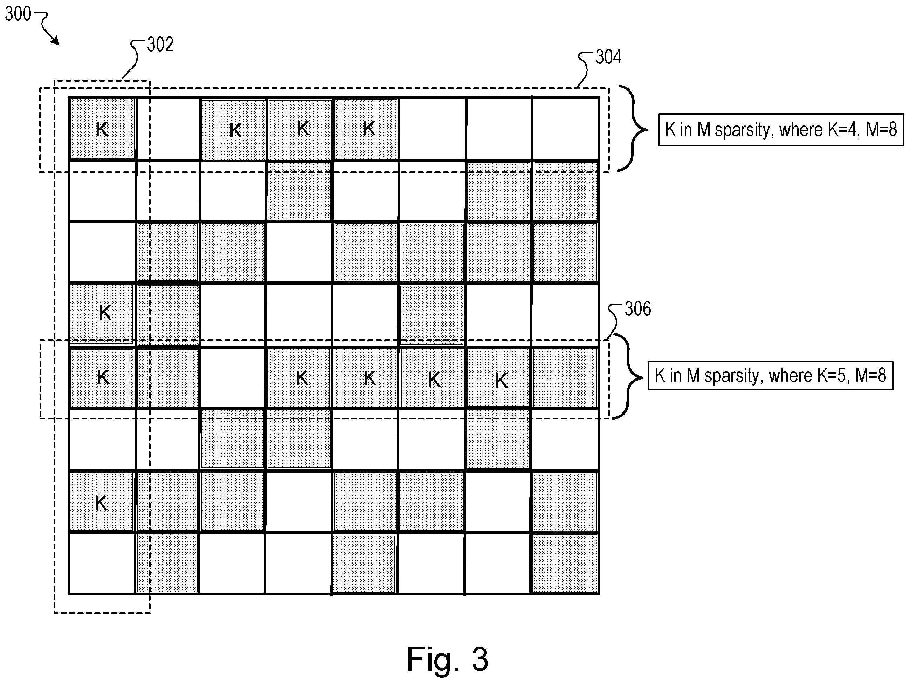

Fig. 3 shows an example parameter tensor 300 with K in M sparsity, which can represent a uniform sparsity format exhibited by sparse tensors. In general, for K in M sparsity, for every next M elements along a dimension (e.g., an innermost dimension) of a parameter tensor, K elements are non-zero.

One or more opcodes can indicate or specify a sparsity attribute of one or more parameter tensors, as well as sparsity along a particular column (or row) dimension of a given tensor. For example, an opcode(s) in a PiM instruction/command received at a PiM architecture of memory device 122 can specify a K in M sparsity of a parameter tensor 300, including K in M sparsity of each column 302 or row 304 of the parameter tensor 300. In some implementations, the tensor sparsity information specified by an opcode is based on a structure or configuration of an instruction set used at system 100.

In the example of Fig. 3, K indicates one or more non-zero values and M is a number of elements associated with the parameter tensor 300. In some examples, M is the number of elements for a given row or column of a parameter tensor. Each of K and M are integers. M can be greater than or equal to one, whereas K can be greater than or equal to zero. The K in M sparsity can be a ratio or some other numerical value that is assigned to, or conveyed as, a sparsity parameter.

The sparsity parameter characterizes a sparsity attribute or measure of sparsity in a dataset or tensor 300. For example, a sparsity parameter can represent a compression ratio for a given {K, M} pair and is equal to K/M, such that if K=2 and M=4, the compression ratio is 50%. The system 100 can support cases where parameters are compressed with reference to one (or more) dimension(s), such as along a column dimension corresponding to column 302. For this particular type of reduction operation, column 302 can be described as a reduction dimension or an inner product dimension. In some implementations, sparsity in a dataset is based on one or more patterns of sparsity that are detectable during a training phase of a neural network model, a deployment phase of the neural network model, or both.

The patterns of sparsity can be uniformly distributed among machine-learning datasets, such as parameter tensors 300 that are processed during the training and deployment phases of model execution. The uniformity of the sparsity patterns allows for a certain measure of predictability that can be exploited to realize efficiencies in acceleration of the neural network model implemented using the PiM architecture 200. For example, and as explained below, patterns of sparsity that are uniformly distributed can allow for predicting, inferring, or otherwise detecting an upcoming pattern (e.g., a sparsity attribute) of zero or non-zero weight values.

In some implementations, control logic of the PiM architecture is configured to predict, explore, and exploit different sparsity patterns to realize additional efficiencies and optimizations in model execution. In the example of Fig. 3, one or more opcodes received at the PiM architecture 200 can indicate that each of column 302 and row 304 includes a K in M sparsity of ½, where K=4, M=8. The control logic of the PiM architecture can receive a sparsity parameter from the SoC 102 or be configured to determine a value for a sparsity parameter based on the logical expression: % *Sparsity = K* ÷ *M.*

In this example the group controller 204 can assign a value of ½ to a respective sparsity parameter for each of column 302 and 304. Relatedly, an opcode received at the PiM architecture 200 can also specify that row 306, which may also be a column, includes a K in M sparsity of 5/8, where K=5 and M=8. In some implementations, the K for a given K in M sparsity is determined based on a hardware layout of the compute units 212, including the hardware layout of an array of MAC cells 214 in each compute unit 212. For example, the K can be determined based on a quantity of MAC circuits in a hardware compute cell of a compute unit 212 at a given PiM block.

Fig. 4 illustrates an example configuration option 400 for routing input data/samples to computing resources of the compute units and obtaining reduced outputs from a reduction circuit in a PiM architecture 200. The configuration option 400 is an example input data routing option that exploits output sparsity.

The configuration option 400 includes multiple compute units 402, which are indicated as "CU" in the example of Fig. 4. Each of compute unit 402 corresponds to the compute unit 212 described above with reference to the example of Fig. 2B. As described above, each compute unit 402 includes arithmetic circuitry for computing accumulated values from one or more inputs in a set of inputs, which is described in more detail below. In some implementations, the example configuration option 400 represents a data routing option for machine-learning computations related to a layer of a neural network that processes inputs, e.g., one or more arrays of pixel values or word tokens, with a parameter matrix, to generate one or more output values for the neural network layer.

In configuration option 400, each of the multiple compute units 402 accepts two values representing operands for a machine-learning (or neural network) computation. A first value/operand 408 is an input activation that is received by each of the compute units 402. A second value/operand 406 is a parameter (or weight) of a parameter/weight matrix that includes a set of weights for a particular neural network layer. The weights can have varying degrees of sparsity as indicated by the different shading/patterns of the example reference blocks that represent different weight values in the example of Fig. 4.

As described above, to compute an output for a neural network layer each input 406 is multiplied with a corresponding weight 408 to generate a partial sum, which may be grouped with other partial sums (or accumulated values) to form a set of accumulated values. In some implementations, the weight is passed directly to a multiplier of the compute unit 402, stored in a weight register of the compute unit 402, or both.

In the example of Fig. 4, the configuration option 400 represents an output reduction mode. Each of the compute units 402 is coupled to a reduction circuit 412 that receives accumulated values generated by each of the compute units 402 and performs a reduction operation to reduce the accumulated values to a corresponding output value 416. In some examples, the reduction circuit 412 is described alternatively as a reduction tree and is a portion of circuitry that is included in, and/or corresponds, to the reduction circuit 225 described above.

Fig. 5 illustrates an example hardware configuration 500 of the PiM architecture 200 that includes an example of the shared datapath 207 and input/shared queue 205 for exploiting at least output sparsity.

Data lines 502 (e.g., dotted lines) in hardware configuration 500 represent a datapath for an output/full reduction mode. The data such as accumulated values that are generated at the compute units 402 flows from each compute unit 402 to the shared queue 205 via the data lines 502. In some implementations, the data traverses a corresponding group controller 204 in route to the shared queue 205. Data lines 504 (e.g., solid lines) in hardware configuration 500 represent a datapath for communications between a host (or I/O) interface (e.g., the host interface 220) and a compute unit 402. More specifically, the data lines 504 are used to pass operands or input samples (e.g., pixels, activations, tokens, etc.) to the compute units 402 for executing machine-learning computation.

The physical connections represented by the data lines 502 and data lines 504 are shared. For example, this shared connection represents a portion of the shared datapath 207 described above. The shared data lines 502, 504 of shared datapath 207 minimizes the hardware footprint of signal lines/connections within the PiM architecture 200. Additionally, sharing the signal path/lines 502, 504 for routing data to and from the compute units 402 may also limit the PiM architecture 200 to one direction of data transfer at a time due to the shared datapath 207. Thus, in some examples, either reduction data (e.g., accumulated values) or host-PiM communication data (e.g., input samples) can traverse the shared path of data lines 502, 504 at a time.

The hardware configuration 500 is used to define an example Reduction-based PiM architecture that excels at exploiting output-activation sparsity, as skipping computations is simplified with all PiM compute units 402 working on the same output space/dimension. In other words, each compute unit 402 of the PiM architecture 200 contributes a portion of the final output, and a reduction process is implemented to combine the outputs of each compute unit 402. If a particular row or subset of a weight matrix includes sparse values (e.g., zero weight value), computations that would have been performed using those values can be skipped, bypassed, or otherwise disabled at the computation units 402 or MAC cells within a compute unit 402.

As noted above, the PiM architecture 200 includes shared datapath 207 (e.g., the data lines 502, 504) for both data read operations and data write operations. For reduction-based PiM architectures, the data read paths 502 of the PiM architecture 200 are used for reading intermediate data from one or more compute units 402, which may include accumulated values or partial sums that are reduced using the reduction circuit 225 and routing those data to the shared queue 205. In the example of Fig. 5, the reduction circuit 225 includes circuitry representing individual reduction adders 506 at each of the group controllers 204, such that localized reduction operations can be performed at one or more of the group controllers 204 based on a configuration mode of the PiM architecture 200.

In addition, the write path 504 is used for host-PiM communication. During PiM command execution by a PiM block, which can include reduction operations, the shared datapath 207 is used for reading intermediate data and is unavailable for communication with a host device via the host interface 220. The reduction and communication conflict limits host-PiM communication during computations from PiM command execution. Therefore, in many cases, host-PiM communication is performed before PiM operations begin. In other words, the resources in the PiM architecture must have all the data/information necessary to successfully perform the target operations.

This potential constraint of the host-PiM communication limits the data values for indexing operations that can be passed to a PiM block 508 and/or compute units 402 when the PiM architecture 200 executes computations for a given PiM command. To address this potential constraint/conflict, this specification describes a programmable auto-indexing mechanism for input/output activations and weight-scale operations when executing computations at the PiM compute units 402.

Fig. 6 illustrates an example auto-indexing framework 600 performed by control logic of the PiM architecture 200 and using one or more compute units 402 of an example PiM block 508.

As discussed above, the reduction and communication conflict can potentially constrain host-PiM communication during PiM command execution. To mitigate performance impacts from this constraint, the PiM architecture 200 is configured to include certain auto-indexing mechanisms for accurate activation and weight scale tracking during PiM command execution. More specifically, certain computing resources of the PiM architecture 200 are configured to determine the required indices and related information for accurate weight scale retrieval and tracking, as well as input/activation indexing, during PiM command execution without relying on information from the host.

The framework 600 illustrates an example programmable auto-indexing mechanism/technique for input and/or output activations, in which the PiM architecture 200 does not need to access index information from a host device via the host interface 220 to determine input and output activation indices when performing machine-learning computations in response to PiM command execution. Upon determining the input and output activation indices, the PiM architecture 200 can perform corresponding memory read operations and/or memory write operations at memory locations associated with the determined indices.

Input activations can be bulk-loaded into PiM registers prior to execution, enabling fast access throughout computation and minimizing the need for disruptive host-PiM communication during processing. In some implementations, to further maximize efficiency, PiM compute units 402 can be configured to determine and/or track the order in which input activations will be consumed during operations. These determinations and order tracking allow for exploiting input-activation access patterns, which enables further optimization of in-memory computations for ML inference execution.

The index information can be required when output activations are stored locally in PiM registers. However, the patterns of the index change for a sequence of PiM operations can vary depending on the specific circumstances, adding complexity. Due to the potential communication bottleneck between the host and PiM blocks, the host/SoC 102 may be unable to directly provide index information to the PiM compute units 402. To address this, control logic of the PiM architecture 200 can be configured such that each PiM compute unit 402 is able to implement its own auto-index generation mechanism. This enables the PiM architecture to manage indices independently (e.g., without index information from the SoC 102) during PiM command execution, improving overall efficiency and autonomy.

In some implementations, input access patterns at a PiM block are regular and deterministic for PiM operations under output sparsity. In these cases, each PiM compute unit 402 can implement an auto-indexing mechanism to keep track of input and output activations. The input access pattern can be programmed using a subset of (e.g., four) register values. The subset can include a "Base_Index" value 602, which refers to a starting index as well as a "current index" register value, which is reset to this base index value when an outermost loop completes.

The subset can also include: i) a "Unit_Size" value 604, which refers to a number of iterations in an innermost loop; ii) an "Inner_Iteration_Count" value 606, which refers to a number of iterations in a middle loop; and iii) an "Outer_Iteration_Count" value 608, which refers to a number of iterations in an outermost loop. In some implementations, the control logic of the PiM architecture 200 can detect or determine when an end of the outermost loop is reached and then reset the "current index" value to the "Base_Index" value 602, such that a process iteration of tracking input and output activations starts over for a subsequent compute iteration.

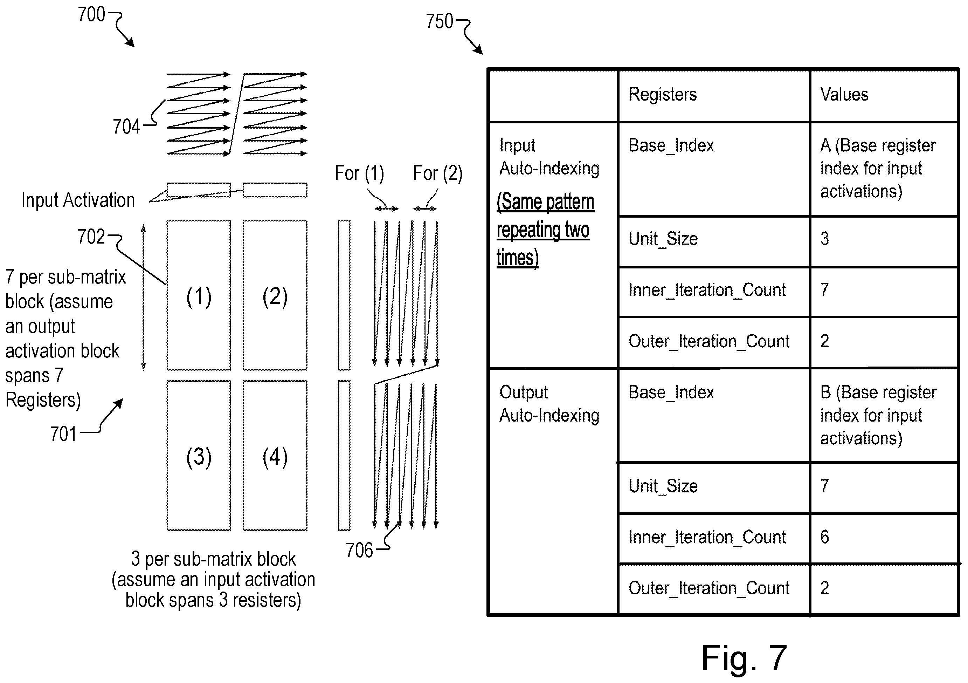

Fig. 7 illustrates an example indexing method 700 of the auto-indexing framework 600, which may be implemented and/or performed using control logic and one or more compute units 402 of the PiM architecture 200, as described above. In the example of Fig. 7, a weight matrix 701 is segmented into four sub-matrices, e.g., sub-matrix 702. The auto-indexing framework 600 is implemented to perform a multiplication of the input activations 704 and weight values of the sub-matrices of the weight matrix 701. Similarly, an auto-index framework is implemented to interpret the output activations 706 that results from the multiplication of the input activations 704 and the weight matrix 701.

In some implementations, each PiM compute unit 402 that is assigned to a particular memory bank 508 may be required to independently maintain and track its assigned inputs as well as provide those corresponding inputs to the MAC cells of that compute unit 402. In this implementation, rather than specify source and destination register information, which potentially requires numerous entries in a PiM instruction buffer if inputs are required to be read from multiple registers, this specification describes an efficient auto-indexing technique that streamlines the process of tracking inputs consumed for given PiM operation.

As described in table 750 of Fig. 7, the example method/implementation 700 includes a "Base_Index" of "A" for the input auto-indexing framework. The implementation 700 includes a "Unit_Size" of 3, an "Inner_Iteration_Count" of 7, and an "Outer_Iteration_Count" of 2. In this example, the "Unit_Size" refers to a number of registers that each sub-matrix 702 spans in a horizontal direction or the number of registers spanned by the input activations 704, the "Inner_Iteration_Count" refers to a number of registers that each sub-matrix 702 spans in a vertical direction, and the "Outer_Iteration_Count" refers to the number of sub-matrices that are present in the horizontal direction of the weight matrix 701.

In some implementations, the "Unit_Size" is determined to be equal to a number of registers spanned by an input activation block, in which, in some implementations, is equal to a number of registers associated with the sub-matrix 702.

As described in table 750, the example implementation 700 includes a "Base_Index" of "B" for the output auto-indexing framework. For the output auto-indexing framework, the example implementation 700 includes a "Unit_Size" of 7, an "Inner_Iteration_Count" of 6, and an "Outer_Iteration_Count" of 2. In this example, the "Unit_Size" refers to a number of registers that each sub-matrix 702 spans in the vertical direction, the "Inner_Iteration_Count" refers to a number of registers that each sub-matrix 702 spans in the horizontal direction multiplied by the "Outer_Iteration_Count" of the input auto-index framework, and the "Outer_Iteration_Count" refers to the number of sub-matrices that are present in the vertical direction of the weight matrix 701.

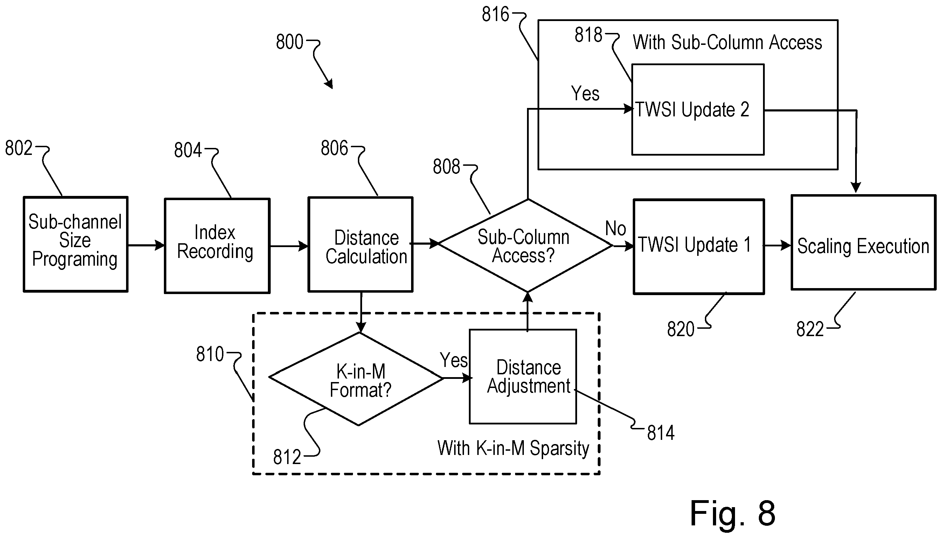

Fig. 8 illustrates an example weight scale indexing framework 800, which may be implemented and/or performed using control logic and one or more compute units 402 of the PiM architecture 200, as described above. The weight scale indexing framework 800 is also implemented based on a distance-based weight-scale index calculation as described below.

In some implementations, skipping or bypassing certain computations based on detected sparsity in a weight tensor causes a non-linear relationship between a weight value and a weight-scale value. This non-linear relationship prohibits an accurate and/or reliable determination of a weight-scale value for a particular weight value. In some cases, a host processor (e.g., HPU 114) can provide weight-scale addresses for a particular weight value during a PiM computation. In the case of a reduction and communication shared datapath conflict described in relation to Fig. 5, each PiM compute unit 402 can be configured to independently determine a mapping between a weight value and a weight-scale value.

In some implementations, a target row and column address of a memory location in a DRAM memory bank 508 are available (e.g., stored/recorded) at each PiM compute unit 402 for a particular weight scale value. Within a DRAM column, 32 weight-scales can be stored/packed together, and the corresponding weights may be stored contiguously in an example format such as [32][SCQ Block Size in number of DRAM columns] to optimize row-buffer locality during alternating access to scales and weights. In this example, SCQ refers to sub-Channel Quantization.

In some implementations, the PiM architecture 200 implements a sub-channel size programming 802 routine. For example, a PiM controller or related control logic of a PiM block programs the "sub-channel size" register. The "sub-channel size" register indicates a size of each sub-channel in terms of DRAM column counts. For example, a sub-channel size with a value of 2 means each sub-channel spans two DRAM columns. A sub-channel block can represent a portion/dimension of an input or weight tensor or matrix, e.g., a subset of rows and columns.

In the framework 800, a PiM block of the PiM architecture 200 is configured to implement an index recording 804. For example, when the PiM block loads a DRAM column of weight scales into a weight-scale register in full-reduction mode, the PiM block stores the corresponding DRAM row and column indices in a "Last Recorded Row" and "Last Recorded Column" register, respectively.

The PiM architecture includes compute logic for implementing a distance calculation 806. In some implementations, the distance calculation 806 includes a distance-based weight-scale index calculation. When a subsequent MAC+NLU (Multiply-Accumulate and Non-Linear Unit) command is executed, the PiM block fetches the row (Current Row) and column (Current Column) indices of the target weights. A distance between the current weight and the last recorded weight scale is then calculated as Distance = (Current Row - Last Recorded Row) * (Columns per Row) + (Current Column - Last Recorded Column). In some implementations, a particular database configuration includes 64 columns per row. Other database configurations can include other numbers of columns per row.

The NLU operation refers to the scaling operation in relation to the weight scale. In addition to the distance calculation 806, the PiM block performs a sparsity check 810 to determine if the weights are in a K-in-M sparsity 812 format (e.g., a K-in-M sparsity mode is enabled), as described in relation to Fig. 3. If the weights are in the K-in-M sparsity 812 format, the PiM block performs a distance adjustment 814 that corresponds to the sparsity of the weight matrix.

The control logic of the PiM architecture 200 determines whether sub-column access 808 is required. More specifically, control logic determines whether a particular target weight scale index update procedure (e.g., TWSI Update 1 or TWSI Update 2) is required based on a sub-column access determination. For example, if a PiM block does not require sub-column access 808, the PiM block performs a first Target Weight Scale Index ("TWSI") update 820. The first TWSI Update 820 updates the TWSI using the calculated distance from the distance calculation 806 and potential distance adjustment 814 and a pre-programmed sub-channel size in relation to the weight matrix. In this case, TWSI = (Distance/Sub-Channel Size) - 1. In both cases (sub-column access and no sub-column access), the PiM block uses the updated TWSI to index into a weight-scale register, and a corresponding weight-scale is employed for the scaling operation of a respective weight value.

If sub-column access is required, then the PiM block executes a second TWSI Update 818 (e.g., TWSI Update 2). If multiple sub-channels are co-located with a particular DRAM column, the column is partitioned into sub-columns. Each sub-column forms a single sub-channel. Access to the weight-scales occurs at a sub-column granularity. However, with sub-column accesses, the index derivation is modified from a standard column distance calculation. In this case, TWSI = (Distance - 1) * Sub-Column Count + Sub-Column Index, where Sub-Column Count is a number of sub-columns with a DRAM column. In some implementations, the Sub-Column Count is obtained based on a value of a PiM instruction field, e.g., "Sub-Column Access Mode." For example, in the case of ½ Sub Column Mode, e.g., Sub-Column Access Mode = 2'b01, the Sub-Column Count is 2. As another example, in the case of a ¼ Sub Column Mode, e.g., Sub-Column Access Mode = 2'b10, the Sub-Column Count is 4.

The Sub-Column Index is an index of a target sub-column. In some implementations, the Sub-Column Index is directly obtained from a PiM instruction field, e.g., "Sub-Column Index." For example, in the case of a ½ Sub Column Mode, the Sub-Column Index is 0 - 1. As another example, in the case of a ¼ Sub Column Mode, the Sub-Column Index is 0-3.

In the case of the PiM block not having sub-column access, the PiM block executes the first TWSI Update 820, as mentioned above. When weights are compressed using the K-in-M sparsity format, one DRAM column is allocated for non-zero bitmaps, followed by corresponding weights. For example, one DRAM column of non-zero bitmaps is followed by four DRAM columns of 4-bit weights (or 8 DRAM columns of 8-bit weights). Since non-zero map columns are factored into distance calculations based on index differences, the distance calculation is adjusted to exclude the columns between the target weights and weight scales. Therefore, if weights are stored in K-in-M format, the distance calculation is adjusted according to the description below.

A modified distance calculation in the case of data stored with K-in-M sparsity includes the original distance calculation, where Distance = (Current Row - Last Recorded Row) * 64 + (Current Column - Last Recorded Column). The PiM block determines an adjusted distance as part of the first TWSI Update 820, where Adjusted Distance = Distance - Non-Zero Map Column Counts. The Non-Zero Map Column Counts for 4-bit weights is CEILING(Distance / 3), where 3 represents 1 column for bitmaps + 2 for weights. Non-Zero Map Column Counts for 8-bit weights is CEILING(Distance / 5), where 5 represents 1 column for bitmaps and 4 for weights. The PiM block uses the adjusted distance in the first TWSI update 820 step, with the rest of the calculation remaining unchanged. A scaling execution step 822, which corresponds to an NLU operation, is performed with the outputs of the appropriate first or second TWSI update steps (818 or 820).

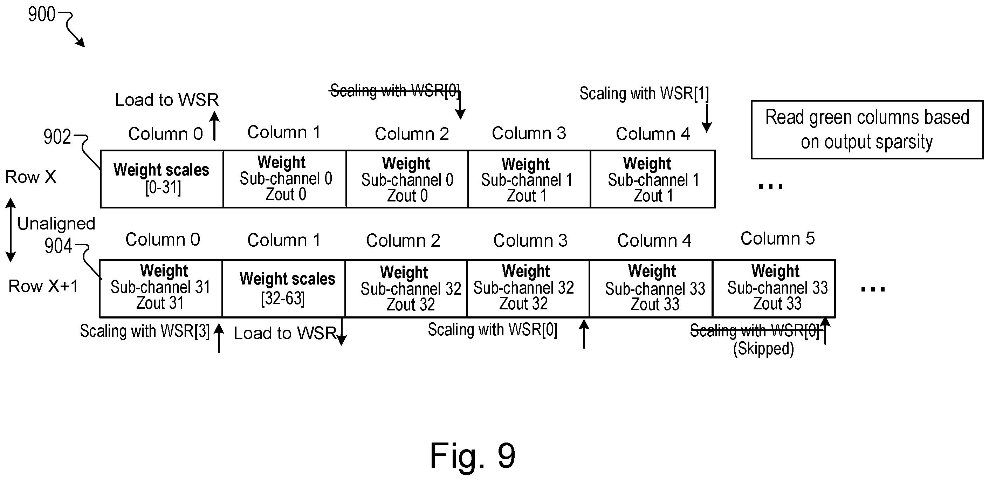

Fig. 9 illustrates a schematic 900 for accessing weight scales under output sparsity conditions. The schematic 900 illustrates a first DRAM row 902 and a second DRAM row 904, where each row stores weight values and weight-scale values associated with a particular neural network layer. Due to output sparsity, e.g., particular rows of weights stored in DRAM are zero, so they are skipped, address locations of weight-scales are not always aligned with address locations of associated weight values. For example, DRAM row 902 illustrates the weight-scales in column 0 and DRAM row 904 illustrates the weight-scales in column 1. In the example schematic 900, only the green columns are read and used in matrix operations due to anticipated output sparsity.

To support sub-channel quantization, e.g., different weight-scales being applied to different sub-sections of a weight matrix, both weight scales and activation scales must be provided to PiM compute units 402 for scaling operations. Because communication to the host is unavailable as described in relation to Fig. 5, the PiM compute units 402 are configured to determine the location of the weight-scales during PiM execution.

Unlike weight scales, activation scales can be relatively small and can be stored in activation-scale registers before PiM execution, allowing for reuse over a sufficient period. Weight scales can be larger and less reusable than activation scales, necessitating reading each weight scale from DRAM memory bank 210 (or 508) during PiM execution. A correct weight scale must be used for each scaling operation from among the weight scales stored in the weight-scale registers (WSR). Output sparsity causes non-linear access to weight scales, making it challenging to selectively determine the correct weight scale to use. Weight scales and weights are not well aligned in DRAM, hindering the direct derivation of the weight-scale index from column addresses, as illustrated by the misalignment of schematic 900. However, a relationship between index locations associated with weights and index locations associated with associated weight-scales can be determined based on a distance between a previously accessed weight and weight-scale pair.

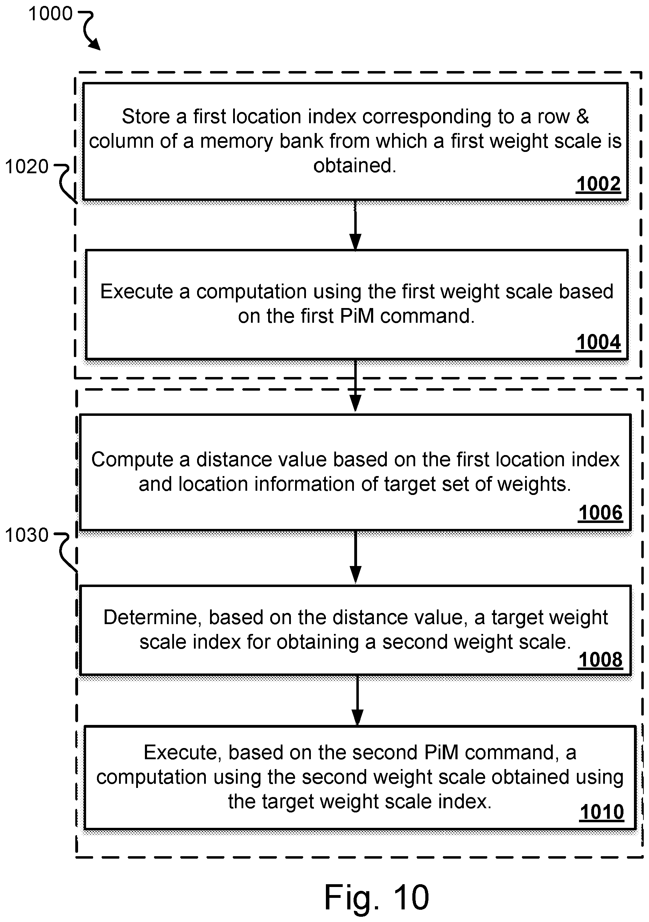

Fig. 10 is an example process 1000 for executing a computation using a weight scale. Process 1000 is also implemented or executed at PiM architecture 200 using at least the compute unit 212 described above with reference to Fig. 2B. Hence, descriptions of process 1000 will reference the above-mentioned computing resources of PiM architecture 200. In some examples, the steps or actions of process 1000 are enabled by programmed software instructions, firmware instructions, or both. Each type of instruction may be stored in a non-transitory machine-readable storage device and is executable by one or more of the processors or other resources described in this specification.

Referring again to process 1000, the PiM architecture 200 receives two PiM commands. For a first PiM command 1020, the PiM architecture 200 stores (1002) a first location index corresponding to a row and column of a memory bank from which a first weight scale is obtained. The PiM architecture 200 then executes (1004) a computation using the first weight scale based on the first PiM command.

For a second PiM command 1030, the PiM architecture 200 computes (1006) a distance value based on the first location index and index location information of a second weight. The PiM architecture 200 determines (1008), based on the distance value, a second weight scale index for obtaining a second weight scale. The PiM architecture 200 executes (1010), based on the second PiM command, a computation using the second weight scale obtained using the second weight scale index.

In some implementations, the respective steps of process 1000 are performed at a hardware integrated circuit as part of a larger compute operation to generate a machine-learning (ML) output, including an output for a neural network layer of a neural network that implements one or more ML models. For example, the output can be a portion of a computation for a ML task or inference workload to generate an image processing, speech processing, or image recognition output. As indicated above, a portion of the integrated circuit can include a special-purpose neural network processor or hardware ML accelerator configured to accelerate computations for generating different types of data processing outputs.

Embodiments of the subject matter and the functional operations described in this specification can be implemented in digital electronic circuitry, in tangibly-embodied computer software or firmware, in computer hardware, including the structures disclosed in this specification and their structural equivalents, or in combinations of one or more of them. Embodiments of the subject matter described in this specification can be implemented as one or more computer programs, i.e., one or more modules of computer program instructions encoded on a tangible non transitory program carrier for execution by, or to control the operation of, data processing apparatus.

Alternatively or in addition, the program instructions can be encoded on an artificially generated propagated signal, e.g., a machine-generated electrical, optical, or electromagnetic signal, that is generated to encode information for transmission to suitable receiver apparatus for execution by a data processing apparatus. The computer storage medium can be a machine-readable storage device, a machine-readable storage substrate, a random or serial access memory device, or a combination of one or more of them.

The term "computing system" encompasses all kinds of apparatus, devices, and machines for processing data, including by way of example a programmable processor, a computer, or multiple processors or computers. The apparatus can include special purpose logic circuitry, e.g., an FPGA (field programmable gate array) or an ASIC (application specific integrated circuit). The apparatus can also include, in addition to hardware, code that creates an execution environment for the computer program in question, e.g., code that constitutes processor firmware, a protocol stack, a database management system, an operating system, or a combination of one or more of them.

A computer program (which may also be referred to or described as a program, software, a software application, a module, a software module, a script, or code) can be written in any form of programming language, including compiled or interpreted languages, or declarative or procedural languages, and it can be deployed in any form, including as a stand-alone program or as a module, component, subroutine, or other unit suitable for use in a computing environment.

A computer program may, but need not, correspond to a file in a file system. A program can be stored in a portion of a file that holds other programs or data, e.g., one or more scripts stored in a markup language document, in a single file dedicated to the program in question, or in multiple coordinated files, e.g., files that store one or more modules, sub programs, or portions of code. A computer program can be deployed to be executed on one computer or on multiple computers that are located at one site or distributed across multiple sites and interconnected by a communication network.

The processes and logic flows described in this specification can be performed by one or more programmable computers executing one or more computer programs to perform functions by operating on input data and generating output. The processes and logic flows can also be performed by, and apparatus can also be implemented as, special purpose logic circuitry, e.g., an FPGA (field programmable gate array), an ASIC (application specific integrated circuit), or a GPGPU (General purpose graphics processing unit).

Computers suitable for the execution of a computer program include, by way of example, can be based on general or special purpose microprocessors or both, or any other kind of central processing unit. Generally, a central processing unit will receive instructions and data from a read only memory or a random access memory or both. Some elements of a computer are a central processing unit for performing or executing instructions and one or more memory devices for storing instructions and data. Generally, a computer will also include, or be operatively coupled to receive data from or transfer data to, or both, one or more mass storage devices for storing data, e.g., magnetic, magneto optical disks, or optical disks. However, a computer need not have such devices. Moreover, a computer can be embedded in another device, e.g., a mobile telephone, a personal digital assistant (PDA), a mobile audio or video player, a game console, a Global Positioning System (GPS) receiver, or a portable storage device, e.g., a universal serial bus (USB) flash drive, to name just a few.

Computer readable media suitable for storing computer program instructions and data include all forms of nonvolatile memory, media and memory devices, including by way of example semiconductor memory devices, e.g., EPROM, EEPROM, and flash memory devices; magnetic disks, e.g., internal hard disks or removable disks; magneto optical disks; and CD ROM and DVD-ROM disks. The processor and the memory can be supplemented by, or incorporated in, special purpose logic circuitry.

To provide for interaction with a user, embodiments of the subject matter described in this specification can be implemented on a computer having a display device. e.g., LCD (liquid crystal display) monitor, for displaying information to the user and a keyboard and a pointing device, e.g., a mouse or a trackball, by which the user can provide input to the computer. Other kinds of devices can be used to provide for interaction with a user as well; for example, feedback provided to the user can be any form of sensory feedback, e.g., visual feedback, auditory feedback, or tactile feedback: and input from the user can be received in any form, including acoustic, speech, or tactile input. In addition, a computer can interact with a user by sending documents to and receiving documents from a device that is used by the user; for example, by sending web pages to a web browser on a user's client device in response to requests received from the web browser.

Embodiments of the subject matter described in this specification can be implemented in a computing system that includes a back end component, e.g., as a data server, or that includes a middleware component, e.g., an application server, or that includes a front end component, e.g., a client computer having a graphical user interface or a Web browser through which a user can interact with an implementation of the subject matter described in this specification, or any combination of one or more such back end, middleware, or front end components. The components of the system can be interconnected by any form or medium of digital data communication, e.g., a communication network. Examples of communication networks include a local area network ("LAN") and a wide area network ("WAN"), e.g., the Internet.

The computing system can include clients and servers. A client and server are generally remote from each other and typically interact through a communication network. The relationship of client and server arises by virtue of computer programs running on the respective computers and having a client-server relationship to each other.

While this specification contains many specific implementation details, these should not be construed as limitations on the scope of any invention or of what may be claimed, but rather as descriptions of features that may be specific to particular embodiments of particular inventions. Certain features that are described in this specification in the context of separate embodiments can also be implemented in combination in a single embodiment. Conversely, various features that are described in the context of a single embodiment can also be implemented in multiple embodiments separately or in any suitable subcombination. Moreover, although features may be described above as acting in certain combinations and even initially claimed as such, one or more features from a claimed combination can in some cases be excised from the combination, and the claimed combination may be directed to a subcombination or variation of a subcombination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system modules and components in the embodiments described above should not be understood as requiring such separation in all embodiments, and it should be understood that the described program components and systems can generally be integrated together in a single software product or packaged into multiple software products.

Particular embodiments of the subject matter have been described. Other embodiments are within the scope of the following claims. For example, the actions recited in the claims can be performed in a different order and still achieve desirable results. As one example, the processes depicted in the accompanying figures do not necessarily require the particular order shown, or sequential order, to achieve desirable results. In certain implementations, multitasking and parallel processing may be advantageous.

## Claims

1. A method performed using a Processing-in-Memory ("PiM") architecture of an integrated memory device, the method comprising:
for a first PiM command:
storing a first location index corresponding to a row and column of a memory bank from which a first weight scale is obtained; and
executing a computation using the first weight scale based on the first PiM command;
for a second PiM command:
computing a distance value based on the first location index and index location information of a second weight;
determining, based on the distance value, a second weight scale index for obtaining a second weight scale; and
executing, based on the second PiM command, a computation using the second weight scale obtained using the second weight scale index.

2. The method of claim 1, wherein storing a location index corresponding to the row and column of the memory bank comprises:
storing the location index in a hardware-controlled register of a PiM block included in the PiM architecture.

3. The method of any of claims 1-2, wherein storing a location index corresponding to the row and column of the memory bank comprises:
i) storing, in a first register, a row index corresponding to a row of the row and column of the memory bank; and
ii) storing, in a second register, a column index corresponding to a column of the row and column of the memory bank.

4. The method of claim 3, wherein:
i) the first register is a weight scale row register; and
ii) the second register is a weight scale column register.

5. The method of any of claims 2-4, further comprising:
loading the weight scale into a weight scale register of the PiM block,
performing, based on the weight scale, a scaling operation in response to executing machine-learning computations at a compute unit of the PiM block.

6. The method of any of claims 1-5, further comprising:
obtaining a plurality of weight scales in response to reading, from the memory bank, respective data values for each of the plurality of weight scales,
wherein each of the plurality of scales is for a scaling operation against a respective weight value used in a machine-learning computation executed by a compute unit of the PiM architecture.

7. The method of any of claims 1-6, further comprising:
configuring an output-activation sparsity exploitation mode of the PiM architecture based on a mode configuration value that indicates a non-linear access pattern for accessing weight scales stored in the memory bank.

8. The method of claim 7, wherein the mode configuration value is a reduction bit that is set in a PiM execute command that is received at the PiM architecture from a host device that communicates with the memory device.

9. The method of claim 8, wherein the reduction bit is set based on a configurable binary value of 0 or 1.

10. The method of claim 9, further comprising:
determining that the reduction bit is set; and
triggering a reduction mode of the PiM architecture in response to determining that the reduction bit is set.

11. A Processing-in-Memory ("PiM") architecture of an integrated memory device, comprising:
at least one processor of a PiM device of the PiM architecture;
a memory of the PiM device storing instructions that, when executed by the at least one processor of the PiM device, cause the at least one processor to perform operations comprising a method of any one of claims 1 to 6.

12. The architecture of claim 11, wherein storing a location index corresponding to the row and column of the memory bank comprises:
i) storing, in a first register, a row index corresponding to a row of the row and column of the memory bank; and
ii) storing, in a second register, a column index corresponding to a column of the row and column of the memory bank, the operations further comprising:
configuring an output-activation sparsity exploitation mode of the PiM architecture based on a mode configuration value that indicates a non-linear access pattern for accessing weight scales stored in the memory bank.

13. The architecture of claim 12, wherein the mode configuration value is a reduction bit that is set in a PiM execute command that is received at the PiM architecture from a host device that communicates with the memory device.

14. The architecture of claim 13, wherein the reduction bit is set based on a configurable binary value of 0 or 1.

15. The architecture of claim 14, the operations further comprising:
determining that the reduction bit is set; and
triggering a reduction mode of the PiM architecture in response to determining that the reduction bit is set.

## Patentansprüche

1. Verfahren, durchgeführt unter Verwendung einer Processing-in-Memory("PiM")-Architektur einer integrierten Speichervorrichtung, wobei das Verfahren umfasst:
für einen ersten PiM-Befehl:
Speichern eines ersten Positionsindex, der einer Zeile und Spalte einer Speicherbank entspricht, aus der eine erste Gewichtsskala erhalten wird; und
Ausführen einer Berechnung unter Verwendung der ersten Gewichtsskala basierend auf dem ersten PiM-Befehl;
für einen zweiten PiM-Befehl:
Berechnen eines Abstandswerts basierend auf dem ersten Positionsindex und Indexpositionsinformationen eines zweiten Gewichts;
Bestimmen, basierend auf dem Abstandswert, eines zweiten Gewichtsskalenindex zum Erhalten einer zweiten Gewichtsskala; und
Ausführen, basierend auf dem zweiten PiM-Befehl, einer Berechnung unter Verwendung der zweiten Gewichtsskala, die unter Verwendung des zweiten Gewichtsskalenindex erhalten wird.

2. Verfahren nach Anspruch 1, wobei Speichern eines Positionsindex, der der Zeile und Spalte der Speicherbank entspricht, umfasst:
Speichern des Positionsindex in einem hardwaregesteuerten Register eines PiM-Blocks, der in der PiM-Architektur beinhaltet ist.

3. Verfahren nach einem der Ansprüche 1-2, wobei Speichern eines Positionsindex, der der Zeile und Spalte der Speicherbank entspricht, umfasst:
i) Speichern, in einem ersten Register, eines Zeilenindex, der einer Zeile der Zeile und Spalte der Speicherbank entspricht; und
ii) Speichern, in einem zweiten Register, eines Spaltenindex, der einer Spalte der Zeile und Spalte der Speicherbank entspricht.

4. Verfahren nach Anspruch 3, wobei:
i) das erste Register ein Gewichtsskalenzeilenregister ist; und
ii) das zweite Register ein Gewichtsskalenspaltenregister ist.

5. Verfahren nach einem der Ansprüche 2-4, ferner umfassend:
Laden der Gewichtsskala in ein Gewichtsskalenregister des PiM-Blocks,
Durchführen, basierend auf der Gewichtsskala, einer Skalierungsoperation als Reaktion auf Ausführen von Maschinenlernberechnungen an einer Recheneinheit des PiM-Blocks.

6. Verfahren nach einem der Ansprüche 1-5, ferner umfassend:
Erhalten einer Mehrzahl von Gewichtsskalen als Reaktion auf Lesen, aus der Speicherbank, jeweiliger Datenwerte für jede der Mehrzahl von Gewichtsskalen,
wobei jede der Mehrzahl von Skalen für eine Skalierungsoperation gegen einen jeweiligen Gewichtswert ist, der in einer Maschinenlernberechnung verwendet wird, die von einer Recheneinheit der PiM-Architektur ausgeführt wird.

7. Verfahren nach einem der Ansprüche 1-6, ferner umfassend:
Konfigurieren eines Ausgangsaktivierungs-Sparsity-Ausnutzungsmodus der PiM-Architektur basierend auf einem Moduskonfigurationswert, der ein nichtlineares Zugriffsmuster zum Zugreifen auf in der Speicherbank gespeicherte Gewichtsskalen angibt.

8. Verfahren nach Anspruch 7, wobei der Moduskonfigurationswert ein Reduktionsbit ist, das in einem PiM-Ausführungsbefehl gesetzt ist, der an der PiM-Architektur von einer Hostvorrichtung empfangen wird, die mit der Speichervorrichtung kommuniziert.

9. Verfahren nach Anspruch 8, wobei das Reduktionsbit basierend auf einem konfigurierbaren Binärwert von 0 oder 1 gesetzt ist.

10. Verfahren nach Anspruch 9, ferner umfassend:
Bestimmen, dass das Reduktionsbit gesetzt ist; und
Auslösen eines Reduktionsmodus der PiM-Architektur als Reaktion auf Bestimmen, dass das Reduktionsbit gesetzt ist.

11. Processing-in-Memory("PiM")-Architektur einer integrierten Speichervorrichtung, umfassend:
mindestens einen Prozessor einer PiM-Vorrichtung der PiM-Architektur;
einen Speicher der PiM-Vorrichtung, der Anweisungen speichert, die, wenn sie von dem mindestens einen Prozessor der PiM-Vorrichtung ausgeführt werden, den mindestens einen Prozessor veranlassen, Operationen durchzuführen, die ein Verfahren nach einem der Ansprüche 1 bis 6 umfassen.

12. Architektur nach Anspruch 11, wobei Speichern eines Positionsindex, der der Zeile und Spalte der Speicherbank entspricht, umfasst:
i) Speichern, in einem ersten Register, eines Zeilenindex, der einer Zeile der Zeile und Spalte der Speicherbank entspricht; und
ii) Speichern, in einem zweiten Register, eines Spaltenindex, der einer Spalte der Zeile und Spalte der Speicherbank entspricht, wobei die Operationen ferner umfassen:
Konfigurieren eines Ausgangsaktivierungs-Sparsity-Ausnutzungsmodus der PiM-Architektur basierend auf einem Moduskonfigurationswert, der ein nichtlineares Zugriffsmuster zum Zugreifen auf in der Speicherbank gespeicherte Gewichtsskalen angibt.

13. Architektur nach Anspruch 12, wobei der Moduskonfigurationswert ein Reduktionsbit ist, das in einem PiM-Ausführungsbefehl gesetzt ist, der an der PiM-Architektur von einer Hostvorrichtung empfangen wird, die mit der Speichervorrichtung kommuniziert.

14. Architektur nach Anspruch 13, wobei das Reduktionsbit basierend auf einem konfigurierbaren Binärwert von 0 oder 1 gesetzt ist.

15. Architektur nach Anspruch 14, wobei die Operationen ferner umfassen:
Bestimmen, dass das Reduktionsbit gesetzt ist; und
Auslösen eines Reduktionsmodus der PiM-Architektur als Reaktion auf Bestimmen, dass das Reduktionsbit gesetzt ist.

## Revendications

1. Procédé mis en œuvre à l'aide d'une architecture de traitement en mémoire (« PiM ») d'un dispositif de mémoire intégré, le procédé comprenant :
pour une première commande PiM :
le stockage d'un premier indice d'emplacement correspondant à une ligne et une colonne d'une banque de mémoire à partir de laquelle un premier facteur d'échelle de pondération est obtenu ; et
l'exécution d'un calcul à l'aide du premier facteur d'échelle de pondération sur la base de la première commande PiM ;
pour une seconde commande PiM :
le calcul d'une valeur de distance sur la base du premier indice d'emplacement et d'informations d'emplacement d'indice d'une seconde pondération ;
la détermination, sur la base de la valeur de distance, d'un second indice de facteur d'échelle de pondération pour obtenir un second facteur d'échelle de pondération ; et
l'exécution, sur la base de la seconde commande PiM, d'un calcul à l'aide du second facteur d'échelle de pondération obtenu à l'aide du second indice de facteur d'échelle de pondération.

2. Procédé selon la revendication 1, dans lequel le stockage d'un indice d'emplacement correspondant à la ligne et à la colonne de la banque de mémoire comprend :
le stockage de l'indice d'emplacement dans un registre à commande matérielle d'un bloc PiM inclus dans l'architecture PiM.

3. Procédé selon l'une quelconque des revendications 1 ou 2, dans lequel le stockage d'un indice d'emplacement correspondant à la ligne et à la colonne de la banque de mémoire comprend :
i) le stockage, dans un premier registre, d'un indice de ligne correspondant à une ligne parmi les ligne et colonne de la banque de mémoire ; et
ii) le stockage, dans un second registre, d'un indice de colonne correspondant à une colonne parmi les ligne et colonne de la banque de mémoire.

4. Procédé selon la revendication 3, dans lequel :
i) le premier registre est un registre de ligne de facteur d'échelle de pondération ; et
ii) le second registre est un registre de colonne de facteur d'échelle de pondération.

5. Procédé selon l'une quelconque des revendications 2 à 4, comprenant en outre :
le chargement du facteur d'échelle de pondération dans un registre de facteur d'échelle de pondération du bloc PiM,
la réalisation, sur la base du facteur d'échelle de pondération, d'une opération de mise à l'échelle en réponse à l'exécution de calculs d'apprentissage automatique au niveau d'une unité de calcul du bloc PiM.

6. Procédé selon l'une quelconque des revendications 1 à 5, comprenant en outre :
l'obtention d'une pluralité de facteurs d'échelle de pondération en réponse à la lecture, à partir de la banque de mémoire, de valeurs de données respectives pour chacun de la pluralité de facteurs d'échelle de pondération,
dans lequel chacun de la pluralité de facteurs d'échelle est destiné à une opération de mise à l'échelle par rapport à une valeur de pondération respective utilisée dans un calcul d'apprentissage automatique exécuté par une unité de calcul de l'architecture PiM.

7. Procédé selon l'une quelconque des revendications 1 à 6, comprenant en outre :
la configuration d'un mode d'exploitation de parcimonie d'activation de sortie de l'architecture PiM sur la base d'une valeur de configuration de mode qui indique un schéma d'accès non linéaire pour accéder à des facteurs d'échelle de pondération stockés dans la banque de mémoire.

8. Procédé selon la revendication 7, dans lequel la valeur de configuration de mode est un bit de réduction qui est défini dans une commande d'exécution PiM qui est reçue au niveau de l'architecture PiM en provenance d'un dispositif hôte qui communique avec le dispositif de mémoire.

9. Procédé selon la revendication 8, dans lequel le bit de réduction est défini sur la base d'une valeur binaire configurable de 0 ou 1.

10. Procédé selon la revendication 9, comprenant en outre :
la détermination du fait que le bit de réduction est défini ; et
le déclenchement d'un mode de réduction de l'architecture PiM en réponse à la détermination du fait que le bit de réduction est défini.

11. Architecture de traitement en mémoire (« PiM ») d'un dispositif de mémoire intégré, comprenant :
au moins un processeur d'un dispositif PiM de l'architecture PiM ;
une mémoire du dispositif PiM stockant des instructions qui, lorsqu'elles sont exécutées par l'au moins un processeur du dispositif PiM, amènent l'au moins un processeur à réaliser des opérations comprenant un procédé selon l'une quelconque des revendications 1 à 6.

12. Architecture selon la revendication 11, dans laquelle le stockage d'un indice d'emplacement correspondant à la ligne et à la colonne de la banque de mémoire comprend :
i) le stockage, dans un premier registre, d'un indice de ligne correspondant à une ligne parmi les ligne et colonne de la banque de mémoire ; et
ii) le stockage, dans un second registre, d'un indice de colonne correspondant à une colonne parmi les ligne et colonne de la banque de mémoire, les opérations comprenant en outre :
la configuration d'un mode d'exploitation de parcimonie d'activation de sortie de l'architecture PiM sur la base d'une valeur de configuration de mode qui indique un schéma d'accès non linéaire pour accéder à des facteurs d'échelle de pondération stockés dans la banque de mémoire.

13. Architecture selon la revendication 12, dans laquelle la valeur de configuration de mode est un bit de réduction qui est défini dans une commande d'exécution PiM qui est reçue au niveau de l'architecture PiM en provenance d'un dispositif hôte qui communique avec le dispositif de mémoire.

14. Architecture selon la revendication 13, dans laquelle le bit de réduction est défini sur la base d'une valeur binaire configurable de 0 ou 1.

15. Architecture selon la revendication 14, les opérations comprenant en outre :
la détermination du fait que le bit de réduction est défini ; et
le déclenchement d'un mode de réduction de l'architecture PiM en réponse à la détermination du fait que le bit de réduction est défini.
